# EUROPEAN PATENT APPLICATION

(11) **EP 4 766 045 A2**
(43) Date of publication of application: **24.06.2026**
(21) Application number: 25225160.8
(22) Date of filing: 18.12.2025
(51) Int. Cl.: H05K 7/14

(54) **INTEGRATED MODULAR BUSWAY RACK POWER DISTRIBUTION SYSTEM**

(30) Priority: 23.12.2024 US 202463738360 P; 17.01.2025 US 202563746704 P; 11.12.2025 US 202519417001
(71) Applicant: Vertiv Corporation, Westerville, OH 43082 (US)
(72) Inventor: Ferguson, Kevin R., Westerville, 43082 (US); Thomas, Caleb, Westerville, 43082 (US); Aldag, Philip R., Westerville, 43082 (US); King, Jeremy R., Westerville, 43082 (US); Grantham, Roy, Westerville, 43082 (US)
(74) Representative: Cousens, Nico

(57) **Abstract**

A system configured to distribute power within a rack is disclosed. The system may include a rack junction box configured to receive power. The system may include a power rail coupled to the rack junction box and configured to receive power from the rack junction box. The system may include one or more power couplers coupled to the power rail and configured to receive power from the power rail and distribute power to a plurality of rack unit loads.

## Description

The present application claims the benefit under 35 U.S.C. § 119(e) of U.S. Provisional Patent Application Serial Number 63/738,360 filed December 23, 2024, and U.S. Provisional Patent Application Serial Number 63/746,704 filed January 17, 2025.

### TECHNICAL FIELD

The present disclosure relates generally to power for rack-mounted equipment, and, more particularly, to modular power distribution for rack-mounted equipment.

### BACKGROUND

As high-performance computing (HPC) and artificial intelligence (AI) drive data center operations to environmental and utilization limits, the need for improved power distribution systems increases. Conventional higher ampacity distribution systems typically use three-phase compatible components for floor and rack mounted power distribution units (PDUs) to support the high-power demands of power supply units (PSU) within or coupled to computer servers used for HPC/AI workload processing. However, zero-U space, or negative-U space, in the back and sides of server racks is typically spatially limited to accommodate a variety of competing components. For example, the zero-U space may be used to accommodate two or more conventional rack PDUs (rPDUs); power cords for servers, and the like; and server cabling for information technology (IT), while also allowing for sufficient and clear airflow paths to reject server heat losses.

Additionally, more recent high density (HD) server loads requiring direct-to-chip liquid cooling (LC) add to the congestion of the zero-U space with liquid cooling distribution manifolds including associated liquid distribution piping/hosing and connectors. For example, the liquid cooling distribution manifolds may include supply and return manifolds. HD servers may produce air-side heat losses (5-20%) yielding relatively high temperatures at the back of the rack. Increased data center ambient air temperatures, such as changes made to support sustainability goals, may further contribute to heat buildup in the back of the rack. rPDUs are typically ambient temperature limited (e.g., limited to 60°C (140°F)) and even if they are operated within limits, over time the elevated temperatures at the back of the rack can diminish the rPDU operational reliability due to heat-stressed branch overcurrent protective devices (OCPD), electronics, and power connections.

Integrating all this technology together may create limited space in the back of server racks resulting in potentially compromised compute reliability or performance, and thermally stressed rPDUs due to diminished server heat rejection effectiveness. Furthermore, access to the physical components (e.g., cables, cooling manifolds) may be hindered due to difficulty in working in a congested space. For example, installing the initial servers, adding additional servers, servicing the servers, and the like, may be hindered by the congestion.

Therefore, there is a need for a system that can mitigate these spatial fit and thermal challenges and improve upon interoperability with the other equipment of a server rack.

### SUMMARY

A system configured to distribute power within a rack is disclosed in accordance with one or more illustrative embodiments of the present disclosure.

A system configured to distribute power within a rack is disclosed in accordance with one or more illustrative embodiments of the present disclosure. In one illustrative embodiment, the system includes a rack junction box configured to receive the power. In another illustrative embodiment, a power rail is coupled to the rack junction box and configured to receive the power from the rack junction box. In another illustrative embodiment, one or more power couplers are coupled to the power rail and configured to receive the power from the power rail and to distribute the power to a plurality of rack unit loads.

In a further aspect, at least a portion of the system may be configured to be located within a zero-U space of the rack, where the zero-U space of the rack is defined as a volume within and at each side and a back of the rack and which is not configured for receiving the plurality of rack unit loads.

In a further aspect, the power rail may include an enclosure. In a further aspect, the power rail may include at least three busbars at least partially enclosed by the enclosure and configured for receiving and electrically coupling to coupler blades of the one or more power couplers.

In a further aspect, the at least three busbars may include at least seven busbars.

In a further aspect, the at least three busbars may include at least eleven busbars.

In a further aspect, in an installed configuration within the rack, the at least three busbars of the power rail may be configured to be disposed lengthwise along a vertical direction within a zero-U space of the rack.

In a further aspect, in an installed configuration within the rack, the at least three busbars of the power rail may be configured to be disposed lengthwise along a horizontal direction within a zero-U space of the rack.

In a further aspect, the rack junction box and the power rail may be configured for six-phase power. In a further aspect, the one or more power couplers may be configured to receive the six-phase power from the power rail and to distribute at least one of three-phase power or single-phase power to the plurality of rack unit loads.

In a further aspect, the rack junction box and the power rail may be configured for three-phase power. In a further aspect, the one or more power couplers may be configured to receive the three-phase power from the power rail and to distribute at least one of three-phase power or single-phase power to the plurality of rack unit loads.

In a further aspect, each power coupler of the one or more power couplers may include the coupler blades aligned in a row and configured to receive the power from the power rail.

In a further aspect, each power coupler of the one or more power couplers may include a mounting feature, where the mounting feature is configured to selectively mechanically couple and decouple each power coupler to and from the power rail.

In a further aspect, each power coupler of the one or more power couplers may include a blade coupling mechanism that is configured to be selectively operated independent from the mounting feature, where the blade coupling mechanism is configured to selectively extend and retract the coupler blades to and from the power rail and to thereby electrically couple and electrically decouple the coupler blades to and from the power rail.

In a further aspect, each power coupler of the one or more power couplers may be dual-orientation and configured to be coupled to the power rail in a first orientation and a second orientation that is rotated 180 degrees relative to the first orientation around an axis along which each power coupler is configured to be coupled with the power rail.

In a further aspect, the rack junction box may include an enclosure. In a further aspect, the rack junction box may include at least one circuit breaker.

In a further aspect, the rack junction box may be configured to receive the power from at least one busway.

In a further aspect, the rack junction box may be configured to simultaneously receive the power from at least two busways.

In a further aspect, the power rail may be configured to receive two or more types of power couplers having different sizes along a finite number of possible positions along the power rail.

A power rail is disclosed in accordance with one or more illustrative embodiments of the present disclosure. In one illustrative embodiment, the power rail includes an enclosure. In another illustrative embodiment, the power rail includes at least three busbars at least partially enclosed by the enclosure and configured for receiving and electrically coupling to coupler blades of one or more power couplers. In another illustrative embodiment, the power rail is configured to receive two or more types of power couplers having different sizes along a finite number of possible positions along the power rail.

In a further aspect, the at least three busbars may include at least seven busbars.

In a further aspect, the at least three busbars may include at least eleven busbars.

This Summary is provided solely as an introduction to subject matter that is fully described in the Detailed Description and Drawings. The Summary should not be considered to describe essential features nor be used to determine the scope of the Claims. Moreover, it is to be understood that both the foregoing Summary and the following Detailed Description are exemplary and explanatory only and are not necessarily restrictive of the subject matter claimed.

### BRIEF DESCRIPTION OF THE DRAWINGS

The detailed description is described with reference to the accompanying figures. The use of the same reference numbers in different instances in the description and the figures may indicate similar or identical items. Various embodiments or examples ("examples") of the present disclosure are disclosed in the following detailed description and the accompanying drawings. The drawings are not necessarily to scale. In general, operations of disclosed processes may be performed in an arbitrary order, unless otherwise provided in the claims.
FIG. 1A is a perspective view of a system configured to distribute power within a rack, in accordance with one or more embodiments of the present disclosure.
FIG. 1B is a perspective view of the system including a plurality of rack unit loads, in accordance with one or more embodiments of the present disclosure.
FIG. 1C is a perspective view of the system including an alternate location and orientation of the rack junction box and the power rail, in accordance with one or more embodiments of the present disclosure.
FIG. 2A is a zoomed-in perspective view of a lower portion of the system, in accordance with one or more embodiments of the present disclosure.
FIG. 2B is a zoomed-in perspective view of an upper portion of the system, in accordance with one or more embodiments of the present disclosure.
FIG. 3A is a rear view of the system, in accordance with one or more embodiments of the present disclosure.
FIG. 3B is a rear view of the system with the plurality of rack unit loads, in accordance with one or more embodiments of the present disclosure.
FIG. 4A is a perspective front view of the system showing OCPD of the rack junction box, in accordance with one or more embodiments of the present disclosure.
FIG. 4B is a zoomed-in front perspective view of an upper portion of the system, in accordance with one or more embodiments of the present disclosure.
FIG. 5A is a top view of a zero-U space defined by the rack, in accordance with one or more embodiments of the present disclosure.
FIG. 5B is a top view of the system inside the zero-U space, in accordance with one or more embodiments of the present disclosure.
FIG. 6A is a side view of a power rail of the system, in accordance with one or more embodiments of the present disclosure.
FIG. 6B is a cross-sectional end view of the power rail including busbars, in accordance with one or more embodiments of the present disclosure.
FIG. 7A is a perspective view of a power coupler of the system including first power interfaces, in accordance with one or more embodiments of the present disclosure.
FIG. 7B is a perspective view of the power coupler of the system including a second power interface for a non-detachable corded adaptor, in accordance with one or more embodiments of the present disclosure.
FIG. 8A is a top view of the power coupler of the system including the second power interface for the non-detachable corded adaptor, in accordance with one or more embodiments of the present disclosure.
FIG. 8B is a perspective view of the power coupler of the system including the second power interface, in accordance with one or more embodiments of the present disclosure.
FIG. 8C is a view of the power coupler of the system including the second power interface for the non-detachable corded adaptor, in accordance with one or more embodiments of the present disclosure.
FIG. 9A is a view of a power whip connector of the power coupler, in accordance with one or more embodiments of the present disclosure.
FIG. 9B is a wire diagram of the power whip connector of the power coupler, in accordance with one or more embodiments of the present disclosure.
FIG. 10 is a diagram of busbars of a power rail and a corresponding table that illustrates alternate methodologies for providing six-phase power to the busbars from busway connection elements, in accordance with one or more embodiments of the present disclosure.

### DETAILED DESCRIPTION

Reference will now be made in detail to the subject matter disclosed, which is illustrated in the accompanying drawings.

Broadly speaking, embodiments of the concepts disclosed herein are directed to a modular busbar-style rack power distribution unit (rPDU) system to distribute power within a rack. In at least some embodiments, the system includes three modular components: a power rail, power couplers coupled to the power rail, and a rack junction box for consolidating power to the power rail. The power rail may be compatible with both three-phase and/or full six-phase technologies. In some embodiments, busbar voltage phase pattern symmetry of the power rail may allow for left and right-side orientations of the power couplers. In some embodiments, due to space limitations, it is to be understood that exact pattern symmetry of the power rail may not be practical. The power rail may be configured to receive two or more types of power couplers having different sizes along a finite number of possible positions along the power rail.

In at least some embodiments, the system is configured to utilize one or more modular busway rack PDUs (rPDUs) for final stage branch circuit splitting to provide polyphase power distribution to equipment power supply units (e.g., rack unit loads). The system may utilize a three-phase to six-phase transformer near the power source origin or first stage sub-feed circuit splitting to provide the three-phase and/or full six-phase. For instance, the system may include, or be coupled to a floor PDU near the source of electrical energy in an overall computing system (e.g., server room).

At least some embodiments described herein relate to power distribution systems implementing high power output (HPO) technology in a modular busway rack PDU that provides enhanced performance characteristics compared to conventional lower power systems. A six-phase system combines two three-phase distribution paths into a single integrated system, requiring less physical space than would be needed for two separate three-phase systems. For the same total power delivery, six-phase systems may use phase busbars rated at half the ampacity of three-phase systems because the power is distributed across six-phases instead of three, allowing each phase conductor to carry approximately half the current. six-phase may provide up to 73% higher power density than three-phase by elevating phase voltages to be greater than 300V for the same volume of conductors and insulation. Furthermore, six-phase may provide up to a 25% reduction of insulation spacings at less than 300V phase voltages for a more compact design of distribution and equipment enclosures. The overhead busway may be configured to be compatible with both three-phase and six-phase power distribution configurations.

In at least some embodiments, the system utilizes the negative-U space, or free-U space, of the rack. The system may support direct vertical busway attachment to an overhead busway, and its terminations may be compartmentalized to slide outward from the rear for easier maintenance and serviceability.

In some embodiments, the system may include additional types of couplers, such as network interface card (NIC) couplers, sensor couplers, and other couplers which may be developed or added to the system later. These couplers may be configured to provide additional functionality to the system, such as communication capabilities, system performance monitoring, or other features.

Conventional rPDU constructions for HPC/AI may be contrary to Six Sigma lean manufacturing principles. These rPDUs may be impractical to build efficiently above 200 kVA (kilovolt-ampere); have relatively higher Defects per Opportunity (DPO) due to the number of wires, fasteners, sensors, connectors, and modules; have less predictable thermal performance due to inconsistency in wire routing and density and variation in generation and proximity to Joule heating; and/or include centralized, multi-channel electronic modules that do not scale easily, lack redundancy, and are less fault tolerant.

In contrast, at least some embodiments of the present disclosure, compared to conventional rPDU designs, have improved DPO due to fewer components. The thermal performance may be more predictable and uniform due to components such as the power rail and rack junction box eliminating the need for unpredictable cable density in custom setups. Furthermore, the use of decentralized, distributed intelligence provides adaptive scalability and greater fault tolerance.

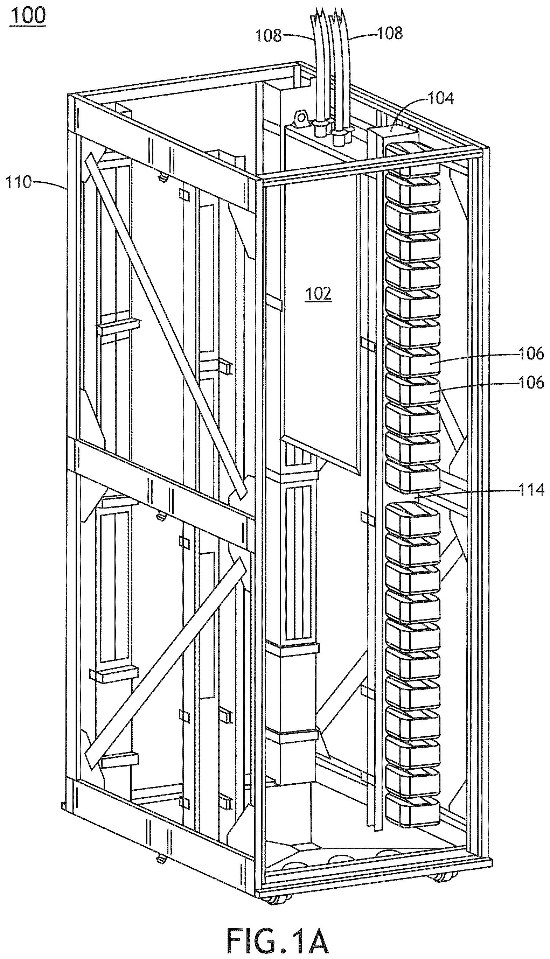

Referring to FIGS. 1A-10, the system 100 of the present disclosure is shown. For purposes of the present disclosure, the term "system 100", "modular system 100", "rack power distribution unit system 100", "modular busbar-style rack power distribution unit (rPDU) system", and variations thereof may be considered equivalent, unless otherwise noted herein.

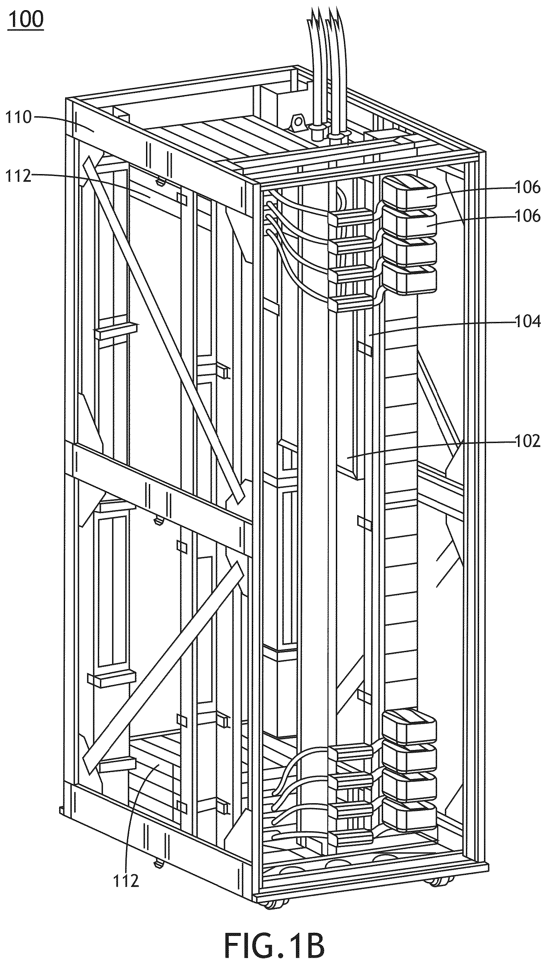

FIG. 1A illustrates a perspective view of a system 100 configured to distribute power within a rack 110 (e.g., server cabinet), in accordance with one or more embodiments of the present disclosure. FIG. 1B illustrates a plurality of rack unit loads 112 installed in the system 100, in accordance with one or more embodiments of the present disclosure.

The system 100 may include a rack junction box 102. The rack junction box 102 may be configured to receive the power. For example, the rack junction box 102 may receive the power through busway connection elements 108 such as cables, conduit, or the like. For instance, cables coupled directly or indirectly to an overhead busway (not shown) may be used.

The system 100 may include a power rail 104. The power rail 104 may be coupled to the rack junction box 102 and may be configured to receive the power from the rack junction box 102.

The system 100 may include one or more power couplers 106. The one or more power couplers 106 may be coupled to the power rail 104 and receive the power from the power rail 104 and distribute the power to the rack unit loads 112. For example, the power coupler 106 may include, or be configured to couple to, a power whip connector configured to distribute power to a rack unit load 112.

In embodiments, the rack junction box 102 and the one or more power rails 104 may be located in any position and in any orientation both inside the rack 110 and outside the rack 110. For example, the rack junction box 102 may be configured to be installed vertically on a side of the rack 110 with a vertical power rail 104 as shown or may be configured to be positioned outside the rack at a first position along a first axis of the rack 110 or at a second position along a second axis of the rack 110 perpendicular to the first axis.

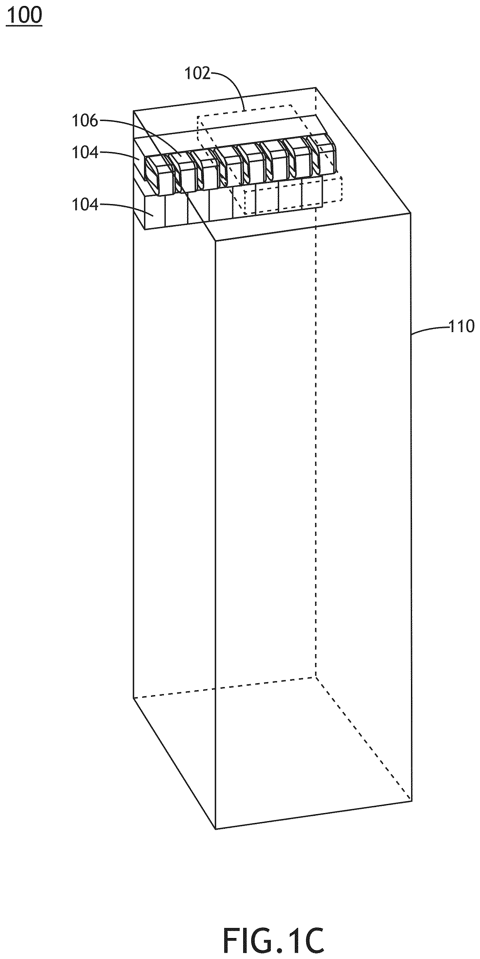

FIG. 1C is a perspective view of the system 100 including an alternate location and orientation of the rack junction box 102 and the power rail 104, in accordance with one or more embodiments of the present disclosure.

In some embodiments, the rack junction box 102 may be configured to be installed horizontally. The rack junction box 102 may be installed in any suitable position, such as at the top of the rack 110 as shown, at the bottom of the rack, or the like. For instance, the rack junction box 102 may be utilized at the top of 24" (600mm) racks that have no side zero-U space.

In some embodiments, the one or more power rails 104 may be configured to be installed with a horizontal orientation. For example, two or more horizontal power rails 104 may be arranged adjacent to a horizontal rack junction box 102 as shown.

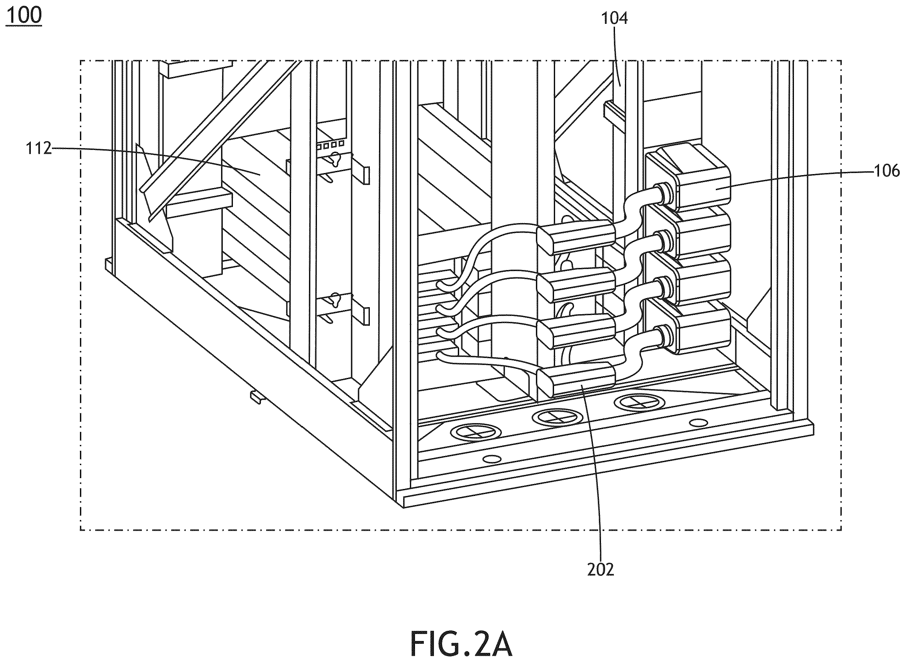

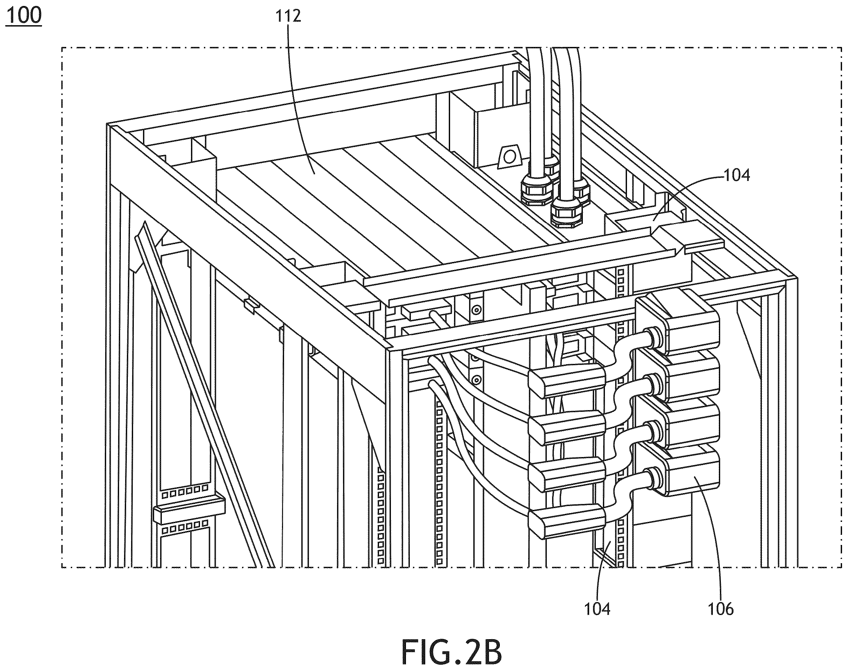

FIG. 2A illustrates a zoomed-in perspective view of a lower portion of the system 100 and FIG. 2B illustrates a zoomed-in perspective view of an upper portion, in accordance with one or more embodiments of the present disclosure.

The power whip connector 202 is shown connected to a rack unit load 112. The power whip connector 202 may be flexible (e.g., cable) and may include one connector or split into two or more connectors for delivering the power.

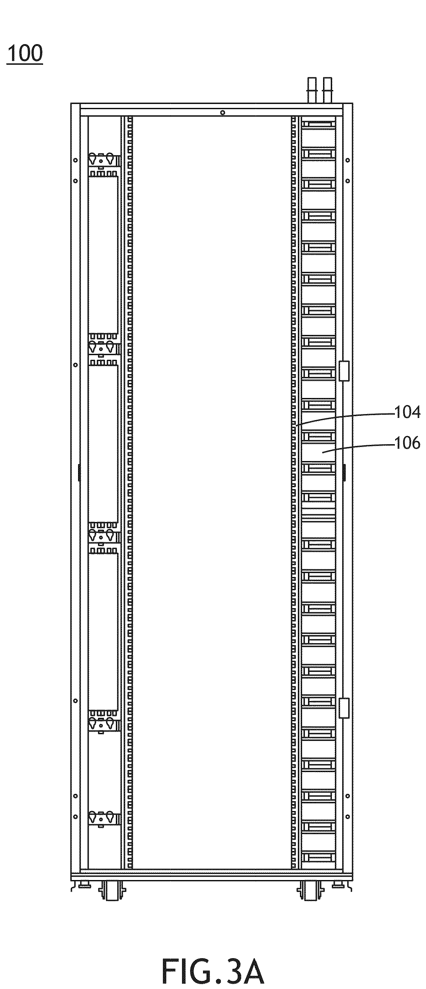

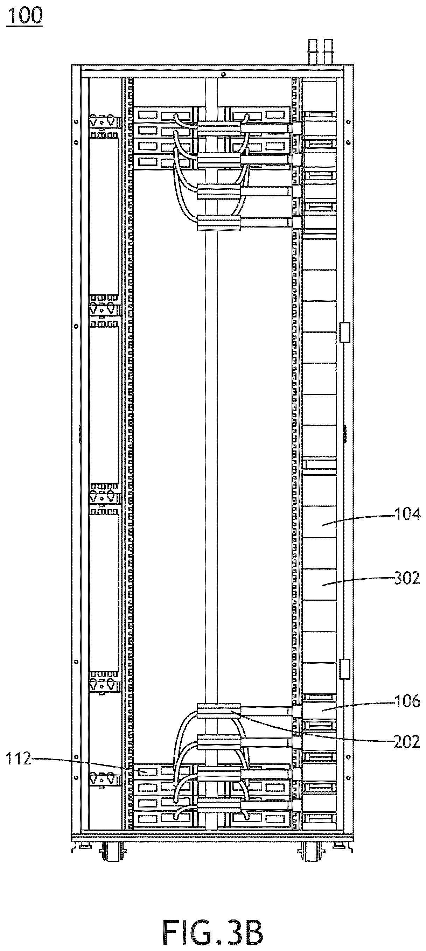

FIGS. 3A and 3B illustrate rear views of the system 100, respectively, with and without power whip connectors 202 and rack unit loads 112, in accordance with one or more embodiments of the present disclosure. Protective covers 302 may couple to the power rail 104 and be used to block unused power coupler positions to prevent ingress of foreign object debris.

The power rail 104 may be configured to couple to any number of power couplers 106. It is contemplated herein that a busbar-style configuration of channels of the power rail 104, unless otherwise noted, allows for more than one position and/or more than one size of the power couplers 106. For instance, the same power rail 104 may be configured to receive two or more types of power couplers 106 having different sizes. In this way, the entire power rail 104 may include one type of power coupler 106 and then later reused for a power coupler 106 of twice the size so that only half as many of the larger power couplers 106 fit on the power rail 104. Other illustrative examples include any type of power coupler 106 of various sizes used in any random order along a finite number of vertical positions due to the flexibility afforded by the power rail 104. For instance, single-phase power couplers may be half the size (e.g., height) of three-phase power couplers 106. Note that the phrase "height" here is used for brevity and is defined as an overall dimension of the power coupler 106 measured in a direction along the length of the power rail 104 and which limits the number of power couplers 106 that can fit on the power rail 104.

In embodiments, the power rail 104 may be configured to couple to ten or more power couplers 106. In embodiments, the power rail 104 may be configured to couple to 20 or more power couplers 106. For example, as shown, 23 power couplers 106 may fit on a single power rail 104.

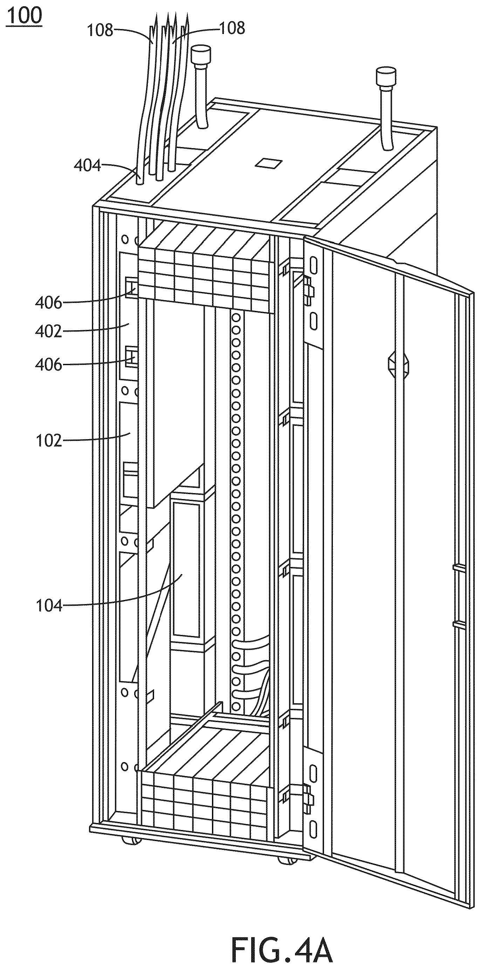

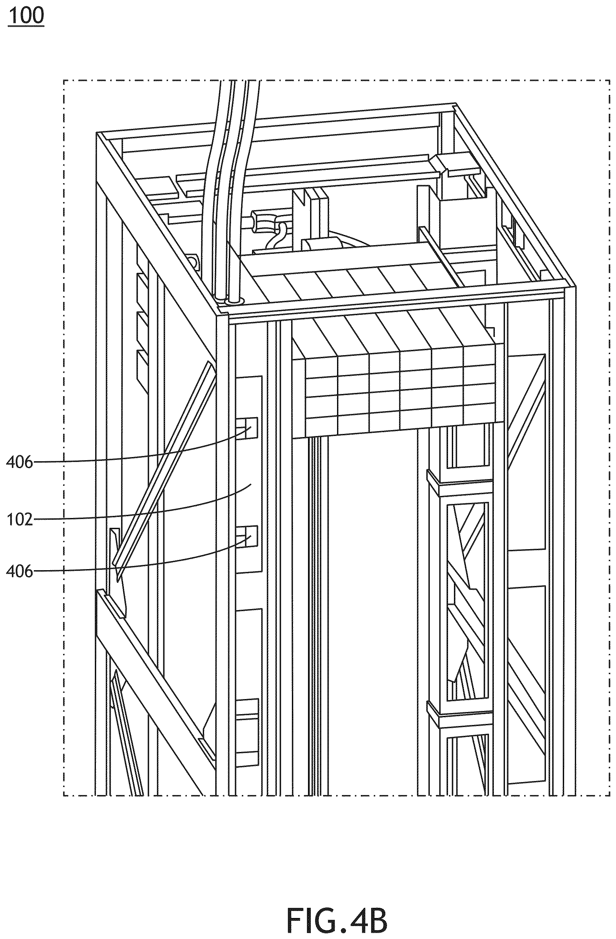

FIGS. 4A and 4B illustrate front views of the system 100 showing an OCPD 406 of the junction box 102, in accordance with one or more embodiments of the present disclosure.

The rack junction box 102 includes an enclosure 402 for housing one or more components.

FIGS. 4A and 4B depict the rack junction box 102 in a specific configuration and position where the rack junction box 102 is located on a side of the rack 110 behind the power rail 104. However, it is contemplated herein that the rack junction box 102 may be arranged in any configuration and include any electrical components suitable for providing power to the power rail 104.

For example, as shown, the rack junction box 102 may include at least one OCPD 406 coupled to the power and configured to protect the system 100 during an electrical fault. By way of another example, the rack junction box 102 may include leak detection sensors configured to turn off the power based on a detection of a water leak. By way of another example, the rack junction box 102 may include smart sensors configured to monitor the power consumption.

In at least some embodiments, the rack junction box 102 consolidates Remote Power Panel (RPP) or Tap Off Box (TOB) whips for relatively efficient termination to the power rail 104.

The rack junction box 102 may be configured for one or more features, such as a combination of two or more of any of the features in this disclosure. In some embodiments, the rack junction box 102 is configured to support electrical connectivity for up to two independent busways. In some embodiments, the rack junction box 102 is directly coupled to one or more overhead busways. In some embodiments, the rack junction box 102 is configured to utilize the zero-U space 502 for space optimization. In some embodiments, the rack junction box 102 is configured to utilize at least one circuit breaker, such as a molded case circuit breaker (MCCB), adjacent a front side of the rack 110 for more convenient access and maintenance. In some embodiments, the rack junction box 102 is configured to utilize at least one of a 3-pole or a 4-pole Molded Case Circuit Breaker (MCCB) for overcurrent protection. Additionally, the rack junction box 102 may include perforated ventilation along its top and bottom surfaces of the enclosure 402 for improved vertical convective airflow. As such, the Molded Case Circuit Breaker (MCCB) and internal termination elements may be preferably positioned lower (e.g., positioned in a lower half) along the front, such as proximate to an ingress for cooler air.

The rack junction box 102 interior surfaces may be painted black for better infra-red (IR) absorption from the heat generating components while the external surfaces may be painted a relatively lighter color than the interior and/or galvanized for better infra-red (IR) reflectivity.

Components (e.g., internal electrically-active components, passive radiative components) of the rack junction box 102 may be coupled to heat sinking elements bonded using a thermal interface material or similar means, to dissipate the heat better to the surrounding air.

The rack junction box 102 may be configured to receive the power using any power coupling elements known in the art of power distribution. The rack junction box 102 may include a power input interface 404 for receiving the power. For example, the power input interface 404 may include an orifice in the enclosure 402, a cable/wire, an electrical connection/plug, and/or the like. The orifice of the power input interface 404 may allow for ingress of the cables and provide strain relief for the cables as well.

The rack junction box 102 may be configured to receive the power from at least one busway. The rack junction box 102 may be configured to simultaneously receive the power from at least two busways. For example, the rack junction box 102 may distribute power from both busways to the power rail 104 for more power. For instance, the busbars 604 of each power rail 104 may be bifurcated along their length to define two or more (e.g., four or more) sets of busbars 604, with each respective set of busbars 604 configured to receive power from a respective busway. The connections to the busway may be directly, or indirectly coupled, such as using a TOB or the like.

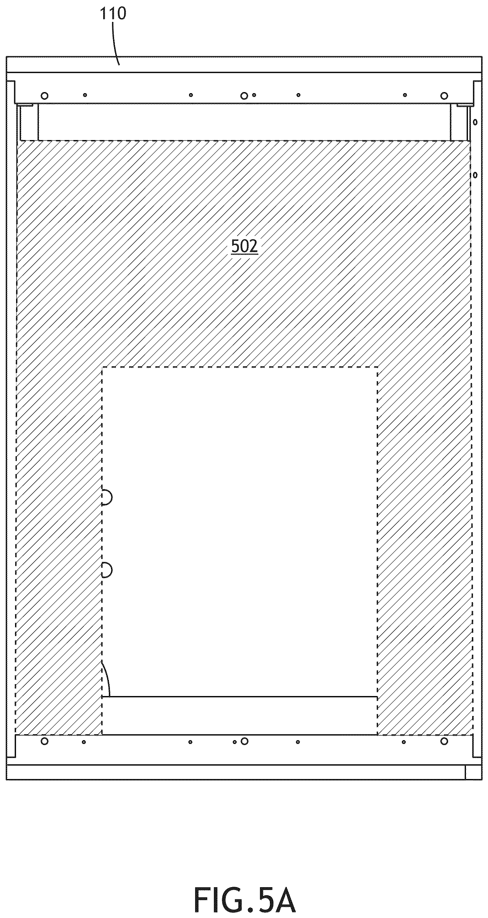

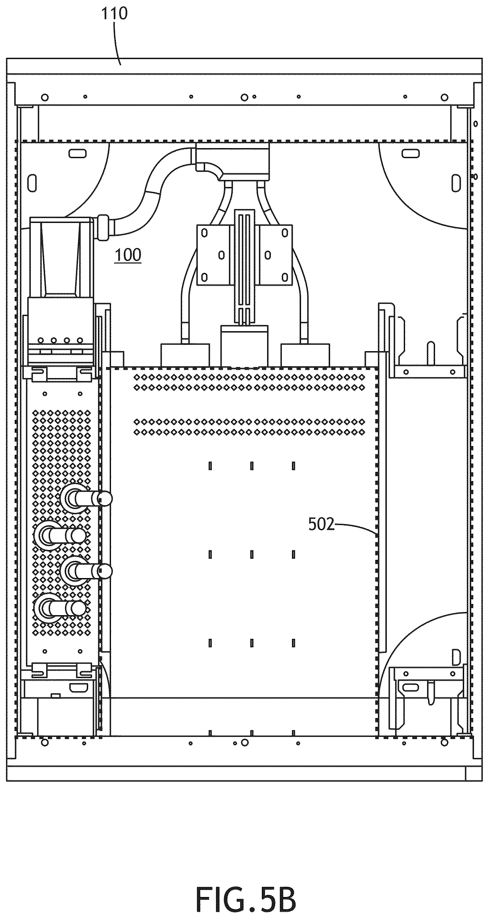

FIG. 5A illustrates a top view of a zero-U space 502 defined by the rack 110, in accordance with one or more embodiments of the present disclosure. FIG. 5B illustrates the zero-U space 502 and how the system 100 may fit inside the zero-U space 502, in accordance with one or more embodiments of the present disclosure.

In embodiments, at least a portion of the system 100 is configured to be located within the zero-U space 502 of the rack 110. For example, besides connections to the overhead busway, the entirety of the system 100 may be included in the zero-U space 502. However, note this is an example configuration and other configurations may include one or more portions of the system 100 extending in non-zero-U space areas.

The zero-U space 502 of the rack 110 may be defined as a volume within and at each side and a back of the rack 110 and which is not configured for receiving the plurality of rack unit loads 112. By way of another example, the zero-U space 502 of the rack 110 may be defined as otherwise unallocated space inside the rack 110 that is not configured for rack unit loads 112. In embodiments, the use of the zero-U space 502 with a modular busbar-style design system 100 facilitates a more efficient and less cluttered method of power delivery than conventional rack PDUs (rPDUs).

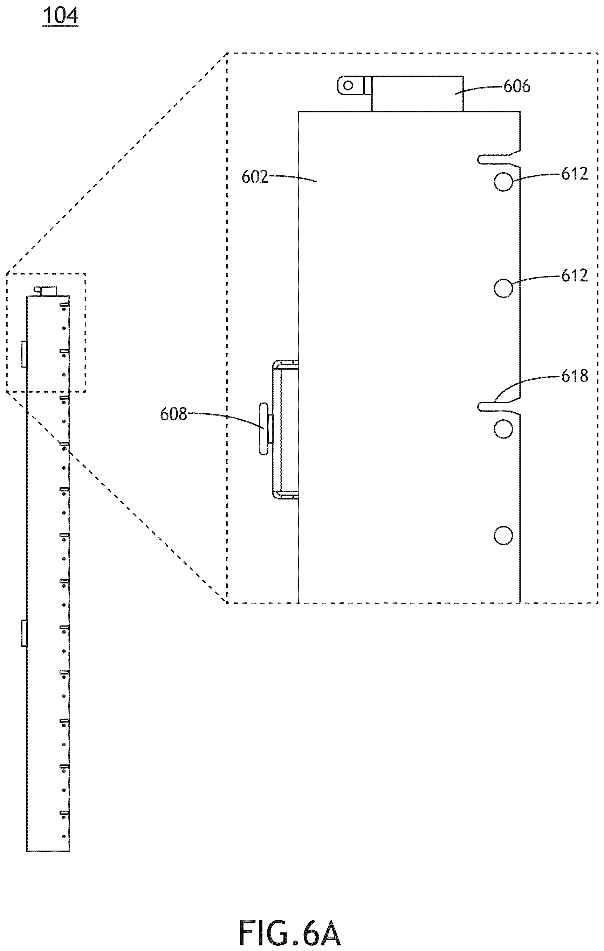

FIG. 6A illustrates a side view of a power rail 104 of the system 100, in accordance with one or more embodiments of the present disclosure.

In at least some embodiments, the power rail 104 is configured to provide three-phase 346/600 V power distribution or six-phase 480/480 V, 50/60 Hz power distribution up to 720 kVA; up to 250 Amperes per phase (A/Φ). The power rail 104 may be configured to include a single set of six-phase busbars or dual three-phase busbars for flexible branch circuit splitting; adjoined vertical linear array or horizontal linear array orientations; an aluminum chassis enclosure 602 with a heat sink element or an integral liquid-cooled plate; side busbar contacts allowing for shuttered busbars 604; a width that is 125 millimeter or less and is configured to be compatible with an adjacent liquid cooling manifold installation; and/or protective covers 302 (shown in FIG. 3B) to block unused channel portions.

In embodiments, the power rail 104 includes an enclosure 602. The enclosure 602 may be configured to at least partially enclose busbars (e.g., conducting channels).

The power rail 104 may include power receiving elements 606. For example, the power receiving elements 606 may include one or more end portions of busbars of the power rail 104 configured to electrically couple to the rack junction box 102 and receive the power. For instance, the power receiving elements 606 may protrude outwards, past the enclosure 602.

The power rail 104 may include power rail mounting surfaces 608. For example, the power rail mounting surfaces 608 may include any mounting surface known in the mechanical arts for mounting components to a frame such as buttons (as shown), hooks, tabs, or the like configured to be removably coupled to receiving features. For instance, the receiving features may include voids (e.g., holes) defined by the frame of the rack 110 or a bracket.

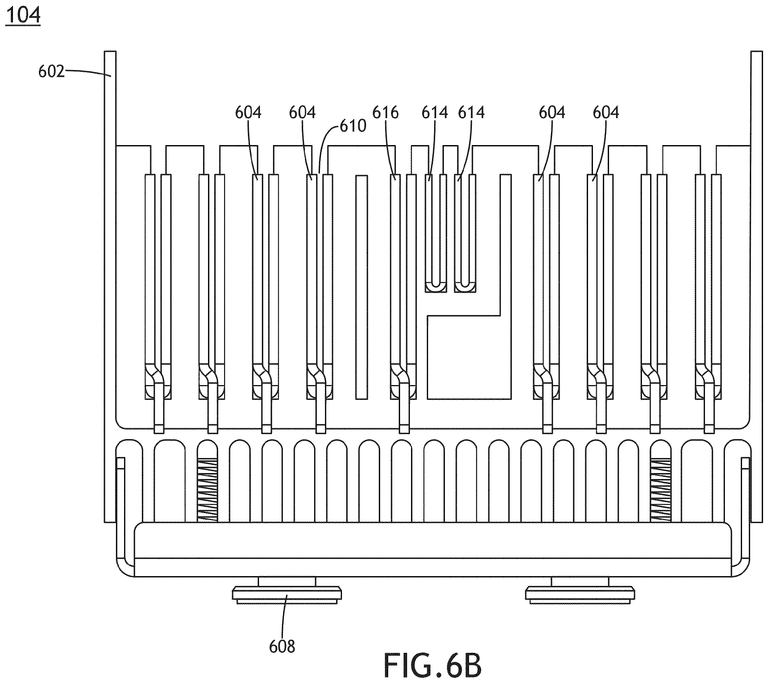

FIG. 6B illustrates a cross-sectional end view of the power rail 104 including busbars 604, in accordance with one or more embodiments of the present disclosure.

The rack junction box 102 and the power rail 104 may be configured for six-phase power, three-phase power, or both. In some embodiments, the power couplers 106 may be configured to receive power from a power rail 104 configured for three-phase and/or six-phase power distribution, and convert it to deliver either three-phase or single-phase power output, based on the specific configuration.

For example, the rack junction box 102 and the power rail 104 may be compatible with six-phase power. The one or more power couplers 106 may be configured to receive the six-phase power from the power rail 104 and to distribute at least one of three-phase power or single-phase power to the plurality of rack unit loads 112.

In another embodiment, the rack junction box 102 and the power rail 104 are configured for three-phase power. The one or more power couplers 106 may be configured to receive the three-phase power from the power rail 104 and to distribute at least one of three-phase power or single-phase power to the plurality of rack unit loads 112.

The power rail 104 may include any number of the busbars 604. In at least some embodiments, each busbar 604 is configured as an electrical conductor for either line, neutral, or protective earth connections in accordance with electrical safety standards. For example, the power rail 104 may include at least five busbars 604. By way of another example, the power rail 104 may include at least seven busbars 604. By way of another example, the power rail 104 may include at least nine busbars 604. By way of another example, the power rail 104 may include at least eleven busbars 604.

The power rail 104 may include multiple independent three-phase sets of power busbars (e.g., busbars 604) running a full length of the power rail 104. Each set of the full-length busbars 604 may be defined separately so that two side-by-side sets of busbars 604 run the full length of the power rail 104. Alternatively, and/or in addition, the busbars 604 may be split lengthwise to define separate end-adjacent electrically independent sets of busbars 604. For example, each set may span a half-length of the power rail 104. In this way, the busbars 604 of the power rail 104 may be realized as two adjoined half-length power rail arrangements that define four independent three-phase sets of busbars 604. For instance, gap 114 of FIG. 1A may define an electrical separation between a first power rail arrangement above the gap 114 and a second power rail arrangement below the gap 114.

Note, for brevity, the discussion of busbars herein may use the term and numeral "busbars 604", but such discussions and limitations (e.g., running lengthwise, adjoined halfway) may, unless otherwise noted, extend to the other busbar elements such as center busbar 616, communication busbars 614, and/or the like.

In some embodiments, the power rail 104 flexibly supports a variety of power distribution modes using only a single configuration of busbars 604. For example, the power rail 104 may include two sets of four busbars 604. This configuration enables the distribution of three-phase power, configured as wye (star) or delta, or six-phase power. For example, when the power rail 104 is configured for a delta three-phase power system, one busbar 604 of each of the two sets may remain unpopulated or unused, as the neutral busbar is unused in delta configurations. In embodiments, the power rail 104 includes a secondary busbar 616 for protective earthing (PE). The secondary busbar 616 may satisfy relevant safety requirements related to PE. In some examples, one or more secondary busbars 616 may be used for PE, such as two or more, or three or more secondary busbars 616. For example, the secondary busbar 616 may be centrally located between the two sets of four or more busbars 604.

In some embodiments, the power rail 104 includes two or more additional busbars 614 configured to transmit communication signals between the power couplers 106 and a host device, such as a web card. The additional busbars 614 may be relatively smaller and centrally-located busbars.

In embodiments where multiple power rails 104 are installed within a single rack 110, the communication busbars 614 may be configured to be electrically connected or daisy-chained among all the power rails 104 to facilitate communication between the power couplers 106 and other couplers across all power rails 104. For example, four or more power rails 104 may be configured within a rack 110, with two power rails 104 on each side of the rack 110. The power rails 104 of each side may be powered by a single respective rack junction box 102. The power rails 104 on the same side of the rack 110 may include communication busbars 614 configured to be contiguous along their fully adjoined length, thereby allowing communication signals to pass along the entire length of the power rails 104.

In embodiments, a bridge element (e.g., small cable bridge) may be provided and configured to connect the communication busbars 614 between the power rails 104 on opposite sides of the rack 110. For example, the cable bridge may include connectors (e.g., RJ-11 connectors with grounded shields) located at the bottom ends of the power rails 104, and may be configured to electrically connect the communication busbars 614 while maintaining electrical isolation and meeting safety standards. This configuration allows for communication signals to be transmitted between couplers on all power rails 104 within the rack 110.

In embodiments, a single network interface card (NIC) coupler may be configured to be in communication with all power couplers 106 and other couplers within the rack 110 by virtue of being communicatively coupled to the communication busbars 614. The NIC coupler may be configured to provide communication and control within the system 100. Therefore, the communication busbars 614 may be configured to provide communication pathways that bridge all the power rails 104, ensuring that an NIC coupler may communicate with couplers on all power rails 104.

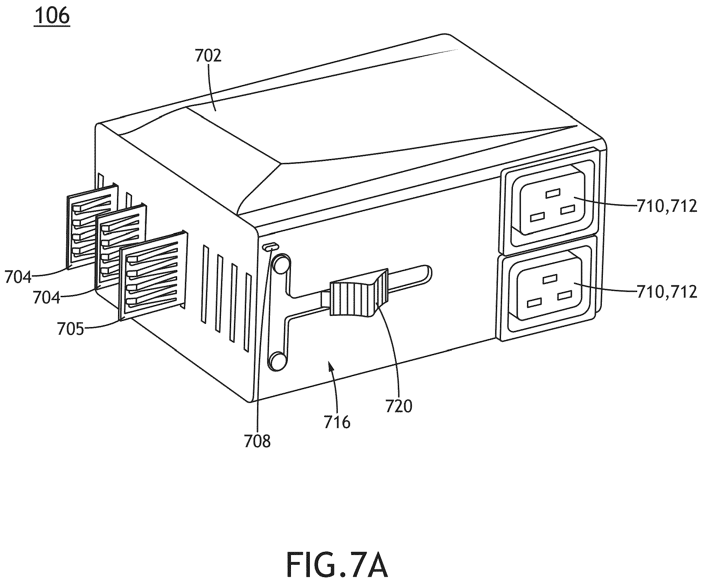

The busbars 604 may be configured to receive and couple (e.g., electrically) to coupler blades (e.g., see coupler blades 704 in FIG. 7A) of the power couplers 106.

Each busbar 604 may include a respective conductive recess 610 (e.g., gap, slot). For instance, the cross-sectional shape of a busbar 604 may include two conductive gapped surfaces defining the conductive recess 610 along the length of the busbar 604. The busbars 604 may be any conductive material. For example, the busbars 604 may include copper. By way of another example, the busbars 604 may include aluminum.

The busbars 604 may include a consistent cross-sectional shape along a full or nearly full length (e.g., 90% or more) of the power rail 104. In this way, multiple power couplers 106 may be configured to couple to multiple locations along the busbar 604 due to its consistent shape.

As shown in FIGS. 1A - 5B, when the busbars 604 are in an installed configuration within the rack 110, the busbars 604 may be configured to be disposed lengthwise along a vertical direction within the zero-U space 502 of the rack 110. For example, the power rail 104 may be installed vertically on one or both sides of the zero-U space 502, and/or at the back or front of the rack 110. The vertical direction may be defined as the direction that the rack unit loads 112 are stacked along and normal to a ground surface when the rack 110 is installed. However, it is contemplated that the power rail 104 may be installed in any suitable orientation and location. For example, as shown in FIG. 1C, the busbars 604 of the power rail 104 may be configured to be disposed lengthwise along a horizontal direction within the zero-U space 502 of the rack 110. For instance, the power rail 104 may be installed horizontally along a side or the back of the rack 110.

FIGS. 7A - 7B illustrate views of the power coupler 106 of the system 100 including various power interfaces 712, 714 in accordance with one or more embodiments of the present disclosure. However, it is contemplated that any power interface 710 known in the art of rPDUs may be used.

In embodiments, each power coupler 106 includes an enclosure 702, such as a housing.

Each power coupler 106 may include coupler blades 704 aligned in a row. The coupler blades 704 may be configured to receive the power from the power rail 104. For example, each coupler blade 704, 705, 706 may be aligned with and configured to selectively couple with a respective busbar 604 of the power rail 104. For instance, the coupler blade 704 may be configured to slide into the respective conductive recess 610 (e.g., slot) of the busbar 604.

Note, for brevity, the discussion of blades herein may use the term and numeral "blade 704" or the like, but such discussions and limitations (e.g., how they couple, their shape) may, unless otherwise noted, extend to the other blades 705, 706.

In embodiments, each coupler, including power couplers 106, NIC couplers, sensor couplers, and any other couplers, may include and operate from its own internal AC/DC offline switching power supply configured to convert AC power received from the power rail 104 into appropriate DC power. By including an internal power supply, a communication bus electrical interface of each coupler may be configured to be electrically isolated, improving the reliability of the communication system within the rack 110.

In embodiments, the blades 704, 705, 706 are configured to be electrically coupled and decoupled in a specific order based on any method such as the length each blade extends from the enclosure 702. For example, a blade 705 (e.g., PE coupler blade) may be longer than blades 704 to ensure it can mate first and break last in a specific sequential order. This provides safety by establishing a PE connection before line connections when coupling the blades and decoupling in a reverse order. In some embodiments, the two smaller blades 706 are low voltage and used for data communication. The coupler blades 704 may include phase coupler blades 704 (e.g., line conductor blades 704) configured for power distribution and/or neutral coupler blades 704 configured as return current paths. For a power coupler 106 configured for single phase power distribution, the PE coupler blade 705 may be longer than the phase coupler blades 704 and the neutral coupler blades 704. For a power coupler 106 configured for three-phase power distribution, the length of coupler blades 704, 705 may be that the PE coupler blade 705 is longer than the neutral coupler blades 704, which are longer than the phase coupler blades 704.

In embodiments, the power couplers 106 may be configured for a sequenced, two-step engagement of the coupler blades 704, 705, 706 using mounting features 708, 709 and a blade coupling mechanism 716. Each power coupler 106 may include mounting features 708, 709 such as a first mounting feature 708 and/or a second mounting feature 709. The first mounting feature 708 may be used to key each power coupler 106 to ensure proper location and orientation. The first mounting feature 708 may correspond to, and be configured to align and couple with, a first receiving feature 618 (e.g., cutout slot) in FIG. 6A. For example, the first mounting feature 708 may include a key (e.g., protrusion). The second mounting feature 709 may be configured to couple and decouple the power coupler 106 to and from the power rail 104 selectively and mechanically. For instance, the second mounting feature 709 may include a tab or the like configured to slide into a second receiving feature (e.g., recess) of the power rail 104 and therefore provide structural support for holding the power coupler 106 in place when installed. An example of the second receiving feature is one or more second receiving features 612 (e.g., recesses, holes) shown in FIG. 6A and defined by enclosure 602.

Each power coupler 106 may include a blade coupling mechanism 716 that may be configured to be selectively operated independent of the one or more mounting features 708, 709. The blade coupling mechanism 716 may be configured to selectively extend and retract the coupler blades 704, 705, 706 to and from the power rail 104 and to thereby electrically couple and electrically decouple the coupler blades to and from the power rail 104. For instance, the blade coupling mechanism 716 may include a sliding feature 720 configured to extend and retract the coupler blades 704, 705, 706 relative to the enclosure 702. For example, the sliding feature 720 may be configured to slide in a slot 718 defined by the enclosure 702. The blade coupling mechanism 716 when in an extended position may be configured to prevent the power coupler 106 from being decoupled/removed from the power rail 104. In the retracted position, the power coupler 106 may be allowed to decouple from the power rail 104.

In some embodiments, the power couplers 106 may be dual-orientation. For example, it is contemplated that a specific six-phase compatible configuration of the power rail 104 of the present disclosure may enable the dual-orientation of the power couplers 106 due to electrical symmetry of the specific arrangement of the busbars 604. For instance, a center, or nearly centered, busbar 616 may be for protective earthing and the other busbars 604 on either side of the center busbar 616 may be symmetrically spaced from the center busbar 616. For example, the power coupler 106 may be configured to be placed in both a first orientation and a second orientation that is rotated 180 degrees relative to the first orientation around an axis along which the power coupler 106 is configured to be coupled with the power rail 104.

In at least some embodiments, the power coupler 106 may include one or more power interfaces 710. For example, the power interfaces 710 may be configured as an International Electrotechnical Commission (IEC) compatible, custom, regional switched and/or metered outlet. The power interfaces 710 may be configured to be one phase to three-phase 240V or 277V, and to distribute up to 16 to 40 Amps. The power interface 710 may be configured for connecting to a non-detachable corded adaptor power whip connector 202 for Open Compute Project (OCP) Compliant Power Shelf compatibility. Alternatively, the power interface 710 may be configured for connecting to a detachable corded adaptor power whip configured to distribute power to the rack unit loads 112.

Alternatively, the power interface 710 may be configured for connecting to an ancillary, detachable device which does not necessarily distribute power to the rack unit loads 112. For example, the ancillary devices may include a network interface card, environmental sensor aggregator, and/or the like. In this way, various functionality and sensors may be added to the power rail 104. In at least some embodiments, the power coupler 106 may be configured in a hot-swappable configuration by virtue of including an over current protection device (not shown) (e.g., hot swappable circuit breaker, a fuse (e.g., 100kAIC fuse) for overcurrent and short circuit fault protection and improved selective coordination, and/or the like). In at least some embodiments, the power coupler 106 may be configured for the following: decentralized, distributed intelligence for adaptive scalability and greater fault tolerance; to conform with International Electrotechnical Commission (IEC) 62053-21 0.5% energy metering and optional residual current monitoring (RCM); and/or to be installed at a finitely/discretely adjustable Rack Unit (U) position (e.g., set of discrete vertical positions) for shortest cable spans to the power rail 104.

As shown in FIG. 7A, the power interfaces 710 may include two or more first power interfaces 712 (e.g., receptacles configured to receive a three-pronged plug).

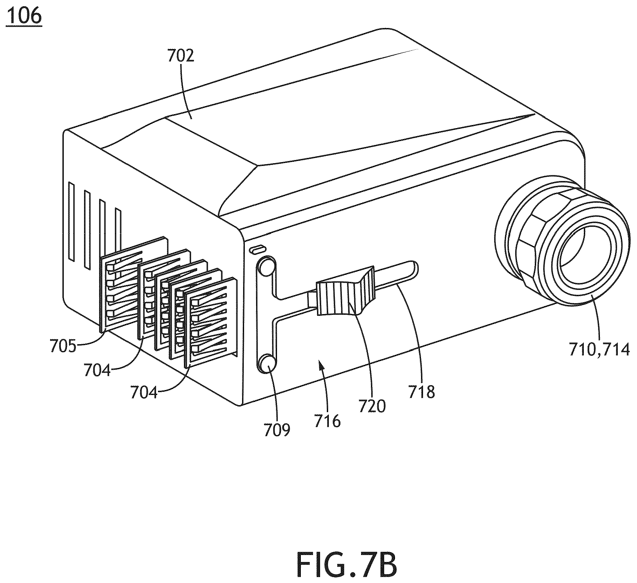

As shown in FIG. 7B, the power interfaces 710 may include a second power interface 714 such as a non-detachable corded adaptor. For example, the second power interface 714 may include a circular recess for receiving a circular cable of a whip or the like. However, in some embodiments, the whip or the like is configured to be detachable.

In embodiments, the power interface 710 may be configured to receive a cable (e.g., power whip connector 202) that passes through the power interface 710 and terminates at the coupler blades 704. For example, the cable may be configured to terminate directly with the coupler blades 704 or indirectly through a circuit board (not shown) or the like.

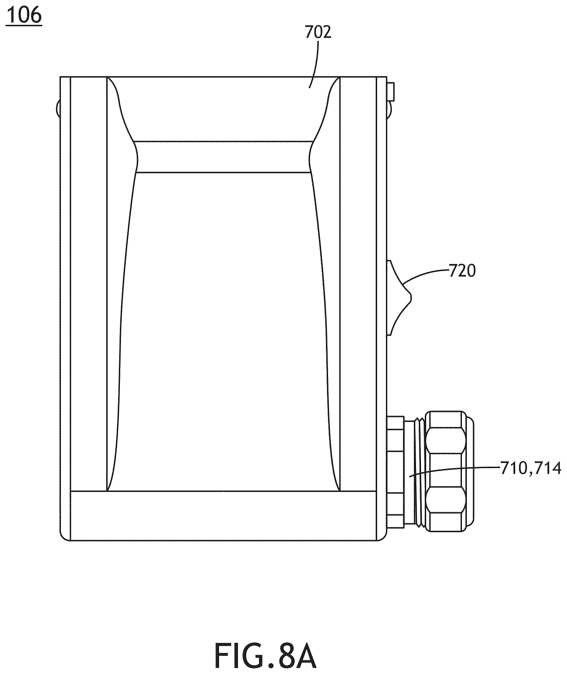

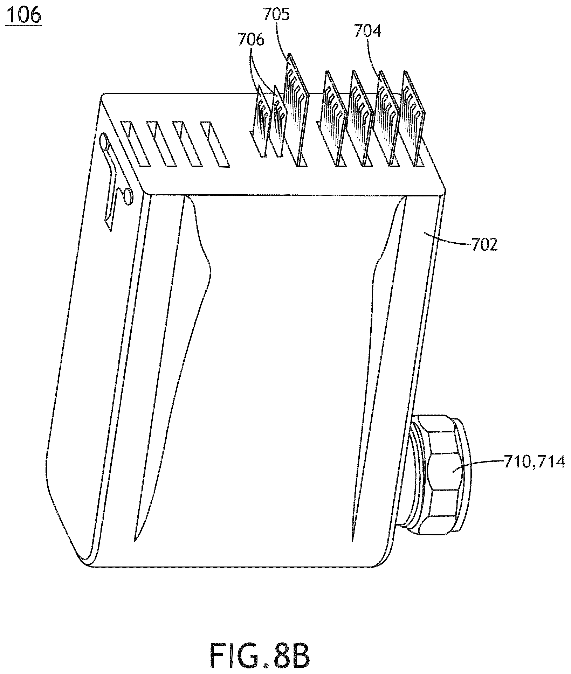

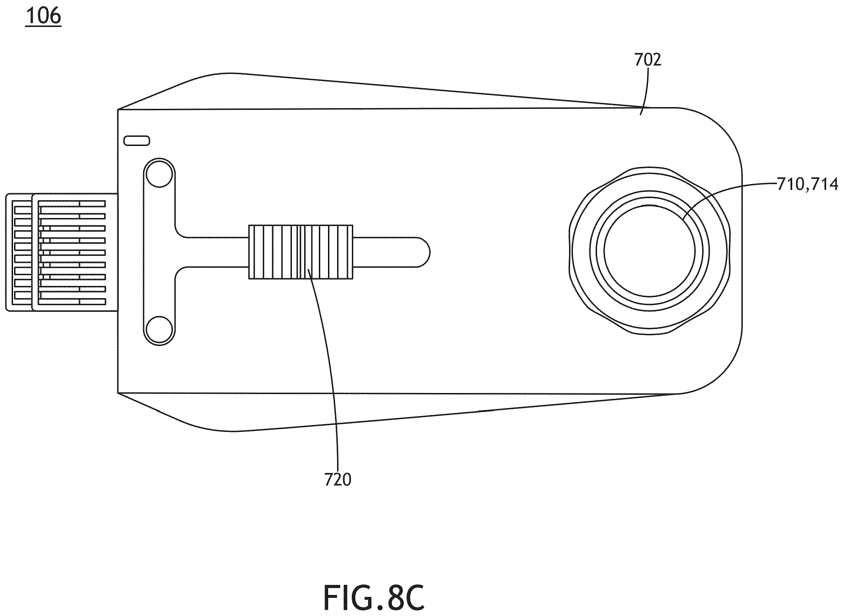

FIG. 8A illustrates a top view of the power coupler 106 of the system 100 including the second power interface for a non-detachable corded adaptor with the coupler blades 704 retracted, in accordance with one or more embodiments of the present disclosure. FIG. 8B illustrates a perspective view of the power coupler 106 of the system 100 including the second power interface 714, in accordance with one or more embodiments of the present disclosure. FIG. 8C illustrates a view of the power coupler 106 of the system 100 including the second power interface 714 for the power whip connector 202, in accordance with one or more embodiments of the present disclosure.

The power coupler 106, as shown, is configured as a monitored three-phase power coupler 106. For example, the power coupler 106 may include one or more additional elements (e.g., additional blades 706) configured for transmitting low voltage data communication signals for monitoring the power distributed. The power coupler 106 may include a secondary blade 705 configured to be used for protective earthing (PE). Blades 704 (e.g., primary blades) may be configured for line and neutral connections. Blades 704 may be configured to align with and couple with busbars 604 shown in FIG. 6B. The secondary blade 705 may be configured to align with and couple with secondary busbar 616. The additional blades 706 may be configured to align with and couple with the additional busbars 614.

In embodiments configured for a single-phase outlet type (e.g., power interface 712), the power coupler 106 may include at least one set of blades 704 configured for line (e.g., power), and neutral, and a blade 705 configured for protective earth (PE). Alternatively, for such a single-phase power interface 712, the power coupler 106 may include a set of three blades configured for line, line, and PE. The set of three blades are configured to physically and electrically couple the single-phase power interface 712 to a set of three corresponding busbars. Furthermore, in some examples, the power coupler 106 includes an additional set such that there are two distinct sets of three blades, each set configured to couple to a corresponding set of three busbars.

In some embodiments configured for a three-phase outlet and/or a power interface 710 configured to be corded, the power coupler 106 includes a set of four or more blades. The set of four or more blades may physically and electrically couple the three-phase outlet and/or the power interface 710 to a set of four or more corresponding busbars. In one example, there are exactly four blades and corresponding busbars. For instance, the four blades may be configured for line, line, line, and PE. In another example, there are exactly five blades and corresponding busbars. For instance, the five blades (e.g., four blades 704 and PE blade 705) may be configured for line, line, line, neutral, and PE.

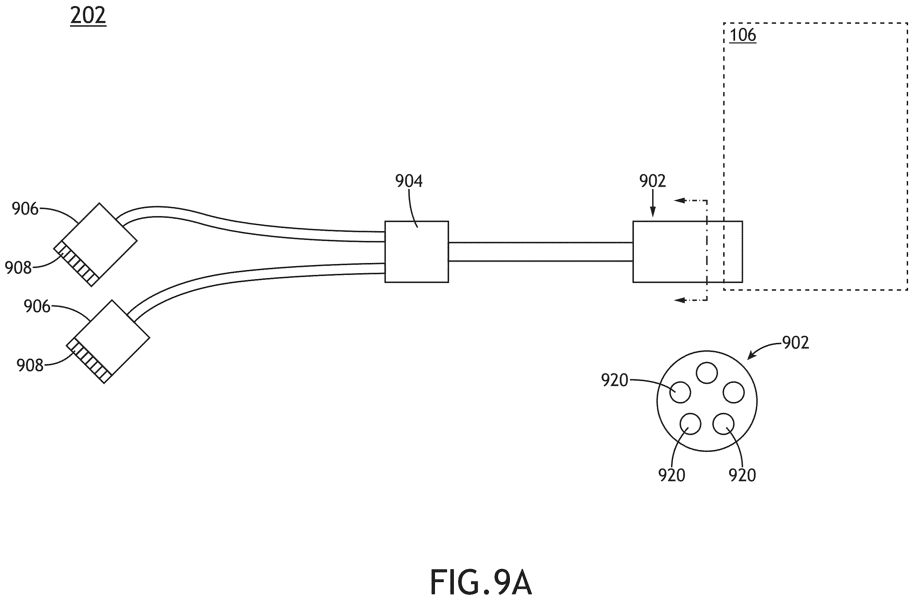

FIG. 9A is a view of a power whip connector 202 of the power coupler 106, in accordance with one or more embodiments of the present disclosure. For example, the power whip connector 202 may be coupled to the power interface 710 of the power coupler 106 as shown in FIG. 2A.

Each power whip connector 202 may be configured to receive the power through a power receiving connector 902 (e.g., detachable corded adaptor connector, non-detachable corded adaptor connector, and/or the like). For instance, the power receiving connector 902 may include one or more input conductive terminals 920 (e.g., terminals such as pins, sockets; soldered wires; and/or the like). For instance, the power receiving connector 902 may include five or more input conductive terminals 920. In one example, the power receiving connector 902 includes exactly five input conductive terminals 920 as shown.

As noted, the power whip connector 202 may be detachable as shown or non-detachable. For example, in a non-detachable configuration, the power whip connector 202 cannot be removed and a power whip connector conductor (e.g., a cable, set of wires, or the like) passes indirectly inside the power coupler 106 and terminates therein. For instance, the power whip connector conductor may be configured to terminate (e.g., couple to) a printed circuit board (not shown) inside the power coupler 106 or the coupler blades 704.

Each power whip connector 202 may be configured to deliver power through one or more connectors 906. For example, the power whip connector 202 may include a splitter 904 configured to split the power to two or more connectors 906. Each connector 906 may include one or more electrical contact elements 908 (e.g., terminals such as pins, sockets, or the like) configured to distribute the power. For instance, as shown, the connectors 906 may include seven or more electrical contact elements 908.

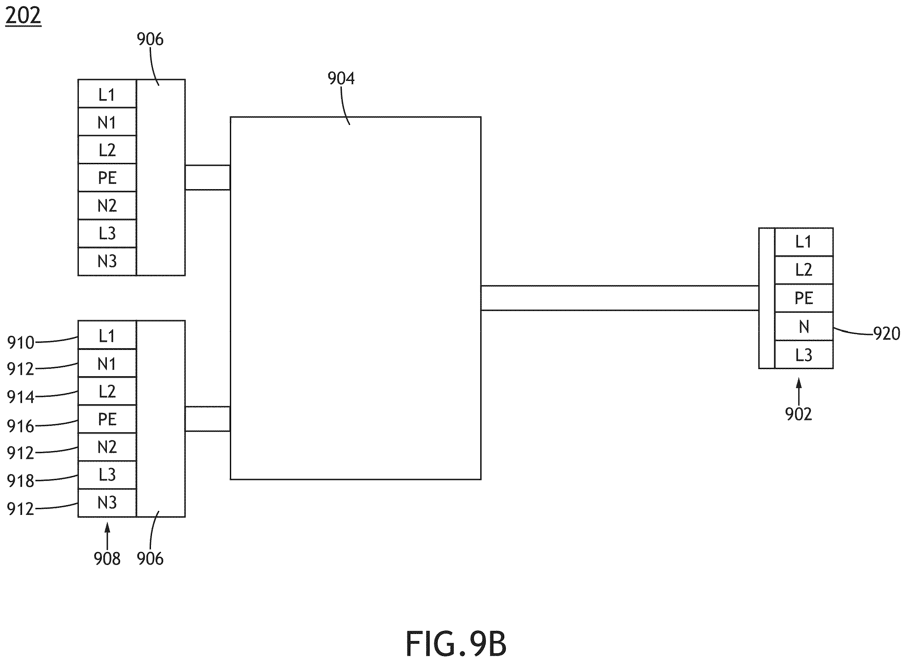

FIG. 9B is a wire diagram of the power whip connector 202, in accordance with one or more embodiments of the present disclosure.

The connector 906 may be wired in any manner suitable for delivering power.

For example, the connector 906 may include splits so that a single neutral input conductive terminal 920 of the power receiving connector 902 is split multiple times and provides a neutral element 912 at the connector 906 that corresponds to each respective line element 910, 914, 918.

In one embodiment, each connector 906 includes a line element 910 L1, a neutral element 912 N1, a line element 914 L2, a PE element 916, a neutral element 912 N2, a line element 918 L3, and a neutral element 912 N3.

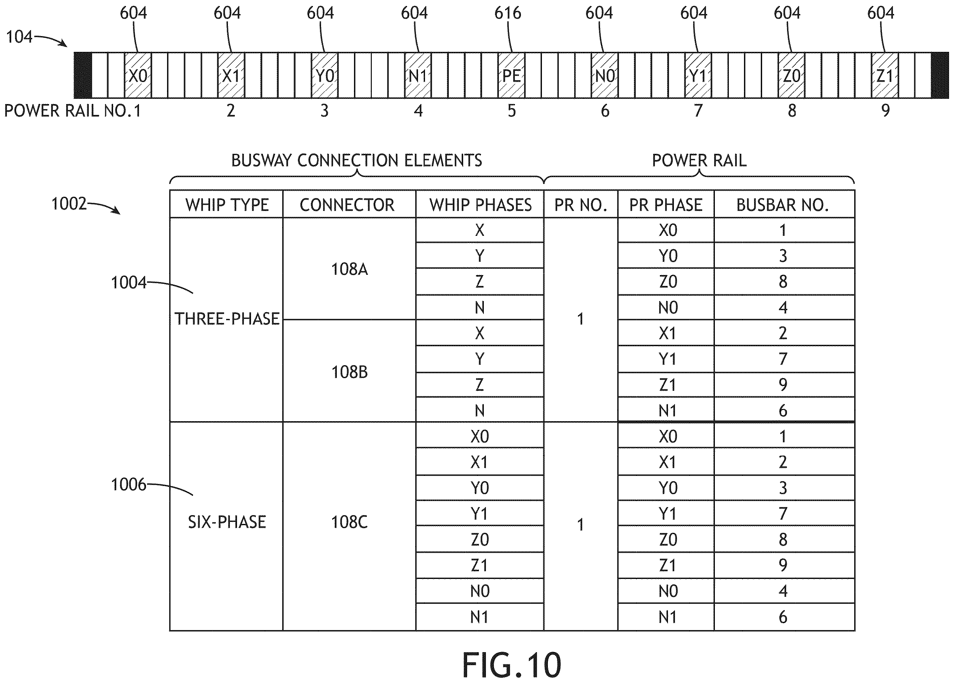

FIG. 10 is a diagram of busbars 604 of a power rail 104 and a corresponding table that illustrates alternate methodologies for providing six-phase power to the busbars 604 from busway connection elements 108 (e.g., overhead busway whips), in accordance with one or more embodiments of the present disclosure. An example of a busway connection element 108 is shown in FIG. 1A and may include any busway connection element 108 known in the art of busways such as a cable, conduit, or the like and may be directly connected to the busway or indirectly connected. The mappings may be used to illustrate how the busway connection elements 108 of FIG. 1A may electrically map to a corresponding numbered order of busbars 604 (i.e., "BUSBAR NO.") of a power rail 104.

Two separate mappings 1004, 1006 are shown in the table 1002. The first mapping 1004 illustrates a mapping between two busway connection elements 108A, 108B configured to each connect to a three-phase busway and receive three-phase power. For example, the two busway connection elements 108A, 108B may be used to tap power twice from the same three-phase overhead busway. The second mapping 1006 utilizes a single busway connection element 108C configured to connect to a single six-phase busway.

Embodiments of the present disclosure may utilize these mappings. For example, in one embodiment, the system 100 may include a rack junction box 102 configured to receive power from two distinct busway connection elements 108 configured for three-phase power each. The rack junction box 102 may be configured to map the connections of the two distinct busway connection elements 108 to provide six-phase power to the power rail 104. In another embodiment, the system 100 may include a rack junction box 102 configured to receive power from a single busway connection element 108 configured for six-phase power. The rack junction box 102 may be configured to map the connections of the busway connection element 108 to provide six-phase power to the power rail 104.

In this way, the system 100 may be configured to flexibly support a variety of power distribution input modes. For example, as shown in table 1002, either two sets of three-phase power connections or a single set of six-phase power connections may terminate at a single power rail 104.

In the table 1002, phases such as X, X0, X1, Y, Y0, Y1, Z, Z0, and Z1 are configured as line conductors for power distribution, while N, N0, and N1 are configured as neutral conductors for return current paths. Note that the mappings shown do not show the mapping of the PE busbar 616 for simplicity only.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the true scope of the subject matter described herein. Furthermore, it is to be understood that the invention is defined by the appended claims.

## Claims

1. A system (100) configured to distribute power within a rack (110), the system comprising:
a rack junction box (102) configured to receive the power;
a power rail (104) coupled to the rack junction box and configured to receive the power from the rack junction box; and
one or more power couplers (106) coupled to the power rail and configured to receive the power from the power rail and to distribute the power to a plurality of rack unit loads (112).

2. The system of Claim 1, wherein at least a portion of the system is configured to be located within a zero-U space (502) of the rack, wherein the zero-U space of the rack is defined as a volume within and at each side and a back of the rack and which is not configured for receiving the plurality of rack unit loads.

3. The system of Claim 1 or 2, wherein the power rail comprises:
an enclosure (402); and
at least three busbars (604) at least partially enclosed by the enclosure and configured for receiving and electrically coupling to coupler blades (704) of the one or more power couplers.

4. The system of Claim 3, wherein the rack junction box is configured to be coupled to at least one of a Remote Power Panel (RPP) whip or a Tap Off Box (TOB) whip for termination to the power rail.

5. The system of Claim 3 or 4, wherein the rack junction box comprises at least one circuit breaker.

6. The system of any of Claims 3 to 5, wherein, in an installed configuration within the rack, the at least three busbars of the power rail are configured to be disposed lengthwise along a vertical direction within a zero-U space of the rack, or wherein, in an installed configuration within the rack, the at least three busbars of the power rail are configured to be disposed lengthwise along a horizontal direction within a zero-U space of the rack.

7. The system of any of Claims 3 to 6, wherein the rack junction box and the power rail are configured for six-phase power and wherein the one or more power couplers are configured to receive the six-phase power from the power rail and to distribute at least one of three-phase power or single-phase power to the plurality of rack unit loads, or
wherein the rack junction box and the power rail are configured for three-phase power and wherein the one or more power couplers are configured to receive the three-phase power from the power rail and to distribute at least one of three-phase power or single-phase power to the plurality of rack unit loads.

8. The system of any of Claims 3 to 7, wherein each power coupler of the one or more power couplers comprises:
the coupler blades aligned in a row and configured to receive the power from the power rail.

9. The system of Claim 8, wherein each power coupler of the one or more power couplers comprises:
a mounting feature (708), wherein the mounting feature is configured to selectively mechanically couple and decouple each power coupler to and from the power rail, and optionally, wherein each power coupler of the one or more power couplers comprises:
a blade coupling mechanism (716) that is configured to be selectively operated independent from the mounting feature, wherein the blade coupling mechanism is configured to selectively extend and retract the coupler blades to and from the power rail and to thereby electrically couple and electrically decouple the coupler blades to and from the power rail.

10. The system of Claim 8 or 9, wherein each power coupler of the one or more power couplers is dual-orientation and configured to be coupled to the power rail in a first orientation and a second orientation that is rotated 180 degrees relative to the first orientation around an axis along which each power coupler is configured to be coupled with the power rail.

11. The system of any preceding Claim, wherein the rack junction box comprises:
an enclosure; and
at least one circuit breaker.

12. The system of any preceding Claim, wherein the rack junction box is configured to receive the power from at least one busway (108), or wherein the rack junction box is configured to simultaneously receive the power from at least two busways.

13. The system of any preceding Claim, wherein the power rail is configured to receive two or more types of power couplers having different sizes along a finite number of possible positions along the power rail.

14. A power rail comprising:
an enclosure; and
at least three busbars at least partially enclosed by the enclosure and configured for receiving and electrically coupling to coupler blades of one or more power couplers,
wherein the power rail is configured to receive two or more types of power couplers having different sizes along a finite number of possible positions along the power rail.

15. The power rail of Claim 14, wherein each power coupler comprises coupler blades of different lengths configured to electrically couple and decouple in a specific sequential order, and/or wherein each power coupler comprises a power interface (710) configured for at least one of an IEC compatible outlet, a non-detachable corded adaptor (202), or a detachable corded adaptor.
